# EUROPÄISCHE PATENTSCHRIFT

(11) **EP 0 391 248 B1**
(45) Veröffentlichungstag und Bekanntmachung des Hinweises auf die Patenterteilung: **29.06.1994**
(21) Anmeldenummer: 90105977.4
(22) Anmeldetag: 29.03.1990
(51) Int. Cl.: G02B 6/42, H01L 21/60, H05K 1/02, H01R 13/66

(54) **Optisch-elektrische Mehrfachverbindung**
Opto-electrical multiconnector
Connecteur multiple opto-électrique

(30) Priorität: 03.04.1989 DE 3910710
(43) Veröffentlichungstag der Anmeldung: 10.10.1990
(73) Patentinhaber: Alcatel SEL Aktiengesellschaft, D-70435 Stuttgart (DE); ALCATEL N.V., NL-1077 XX Amsterdam (NL)
(72) Erfinder: Lösch, Kurt, Dr., D-7000 Stuttgart 1 (DE); Florjancic, Matjaz, Dr., D-7141 Murr (DE)
(74) Vertreter: Pechhold, Eberhard, Dipl.-Phys.

(56) Entgegenhaltungen:
- EP-A- 0 102 525
- IEEE SPECTRUM, Band 24, Nr. 2, März 1987, Seiten 30-35, New York, US; L.D. HUTCHESON et al.: "Optical interconnects replace hardwire"
- APPLIED OPTICS, Band 28, Nr. 1, 1. Januar 1989, Seiten 40-47, New York, US; D.H. HARTMAN et al.: "Radiant cured polymer optical waveguides on printed circuit boards for photonic interconnection use"

## Beschreibung

Die Erfindung betrifft eine Schaltkreisanordnung nach dem Oberbegriff des Patentanspruchs 1.

Aus dem Fachbuch "Hybridintegration", erschienen 1986 im Dr. Alfred Hüthig Verlag, Heidelberg, ist auf Seite 219 ff. in Abschnitt 8.3.3 das sogenannte Tape-Automated-Bonding (TAB) oder Film-Bonden beschrieben. Bei diesem Simultankontaktierungsverfahren wird ein integrierter Schaltkreis mit einem Substrat über einen flexiblen Zwischenträger verbunden. Der flexible Zwischenträger ist einer flexiblen Leiterplatte entnommen, die z.B. in Form eines handelsüblichen Kinofilms konfektioniert ist und aus mehreren Schichten auf einer Polyimidfolie besteht. Die flexible Leiterplatte kann einseitig oder doppelseitig kaschiert sein. Die zur Verbindung benötigten Leiterbahnen werden nach bekannten Verfahren auf der Leiterplatte erzeugt.

Zur Herstellung der Verbindung wird zunächst der integrierte Schaltkreis in einen aus der flexiblen Leiterplatte ausgestanzten Ausschnitt eingesetzt, in den die auf der Leiterplatte geschaffenen Leiterbahnen ein Stück weit frei hineinragen.

Anschließend werden die Leiterbahnen mit geeigneten Anschlußelementen des integrierten Schaltkreises simultan verbunden.

Diesem ersten Kontaktierungsschritt, dem sogenannten Inner-Lead-Bond (ILB) folgt als zweiter Kontaktierungschritt die Verbindung des Zwischenträgers mit dem Substrat, das die Schaltung enthält, in der der integrierte Schaltkreis arbeiten soll.

Bei diesem zweiten Kontaktierungsschritt, dem sogenannten Outer-Lead-Bond (OLB), wird der integrierte Schaltkreis zusammen mit dem umgebenden, den flexiblen Zwischenträger bildenden Teil der flexiblen Leiterplatte aus dieser ausgestanzt und die zur Verbindung mit dem Substrat vorgesehenen Leiterbahnen des so entstandenen Zwischenträgers mit Leiterbahnen des Substrats simultan verlötet.

Ein Vorteil der zweischrittigen Kontaktierung ist u.a. die Möglichkeit, den auf der flexiblen Leiterplatte montierten integrierten Schaltkreis nach dem ersten Kontaktierungsschritt verschiedenen Tests unterziehen und so fehlerhafte Exemplare aussondern zu können. Die für diese Tests erforderlichen Anschlüsse können auf der flexiblen Leiterplatte zusammen mit den für die Schaltkreisanordnung vorgesehenen Leiterbahnen hergestellt werden. Sie bleiben nach dem zweiten Kontaktierungsschritt auf der nicht mehr benötigten Leiterplattenfläche zurück.

Integrierte Schaltkreise, die auf flexiblen Film befestigt sind, werden auch in dem Dokument EP-A-102 525 offenbart.

In letzter Zeit werden zunehmend integrierte Schaltkreise diskutiert und entwickelt, die neben elektrischen Funktionen auch optische Funktionen beinhalten und zu diesem Zweck mit optischen Wellenleitern verbunden werden müssen.

In dem Fachbuch "Hochtechnologie-Multilayer" von H. Müller, erschienen im Eugen. G. Leuze Verlag, 7968 Saulgau, sind in Kapitel 5.7 (Seite 273 ff.) verschiedene heute mögliche Verbindungstechniken für optische Wellenleiter diskutiert. Neben diskret verlegten Fasern werden photolithographisch erzeugte optische Streifenleiter in die Diskussion einbezogen. Die Ankopplung von optischen Streifenleitern an integrierte Schaltkreise erscheint hier angesichts der Genauigkeitserfordernisse zu aufwendig für eine breitere Anwendung.

Der Erfindung liegt die Aufgabe zugrunde, eine aus optische Bauelemente enthaltenden integrierten Schaltkreisen und einem optische Bauelemente enthaltenden Schaltungsträger bestehende Schaltkreisanordnung anzugeben, die einfach herzustellende optische und elektrische Verbindungen aufweist.

Diese Aufgabe wird durch die im kennzeichnenden Teil des Patentanspruchs 1 angegebenen Merkmale gelöst.

Durch die Anordnung optischer Wellenleiter auf einem flexiblen Zwischenträger werden aufwendige, einzeln herzustellende optische Verbindungen durch eine Simultan-Verbindungstechnik ersetzt, die aufgrund ihrer Ähnlichkeit mit dem oben beschriebenen, für elektrische Verbindungen bekannten, automatisch ablaufenden Film-Bonden (TAB) die Möglichkeit bietet, optische und elektrische Verbindungen nach einem einzigen Verfahren und mit denselben Einrichtungen automatisch herzustellen.

Besonders vorteilhaft hinsichtlich der Verbindung von sowohl optische als auch elektrische Funktionen aufweisenden Bauelementen erscheint die im Anspruch 2 beschriebene Anordnung von elektrischen und optischen Leitungselementen auf demselben Zwischenträger. Die optischen Leitungselemente sind in Zwischenräumen zwischen elektrischen Leitungselementen angeordnet oder dort erzeugt. Sie beeinflussen dort die elektrische Isolation der elektrischen Leitungselemente voneinander nicht und sind selbst durch die Lötverbindungen der benachbarten elektrischen Leitungselemente mechanisch geführt und befestigt.

Aufgrund dieser Führung entfällt eine besondere Justage der optischen Leitungselemente. Sollte die Zahl der benötigten elektischen Leitungselemente im Vergleich zu der der optischen Leitungselemente klein sein, so können Leiterstreifen ohne elektrische Funktion, nur zur Befestigung der optischen Leitungselemente vorgesehen werden. Anstelle einer Befestigung mit Hilfe von metallischen Leiterstreifen können die optischen Wellenleiter auch gemäß Anspruch 3 durch Kleben mit dem flexiblen Zwischenträger verbunden oder in eine optische Vergußmasseschicht eingebettet sein.

Gemäß einer im Patentanspruch 4 beschriebenen Ausgestaltung der Erfindung können anstelle von optischen Faserleitern auch photolithographisch hergestellte optische Streifenleiter als Leitungselemente dienen.

Der Gegenstand des Patentanspruchs 5 betrifft die Möglichkeit, optische Funktionselemente, die sonst kostbare Flächenanteile auf dem Halbleiter des integrierten Schaltkreises beanspruchen würden, auf den Zwischenträger auszulagern.

Anspruch 6, schließlich, betrifft ein Verfahren zur Herstellung einer Schaltkreisordnung nach der Erfindung.

Anhand von drei Figuren soll nun ein Ausführungsbeispiel der Schaltkreisanordnung nach der Erfindung ausführlich beschrieben werden.
- Fig 1: zeigt schematisch einen Querschnitt durch ein Substrat mit eingesetzten Halbleiterchips mit elektrischen und optischen Funktionen.
- Fig 2: zeigt ein Substrat mit eingesetzten Halbleiterchips in Draufsicht.
- Fig 3: zeigt einen flexiblen Zwischenträger als Teil einer flexiblen Leiterplatte vor seiner Verbindung mit einem Halbleiterchip und einem Substrat.

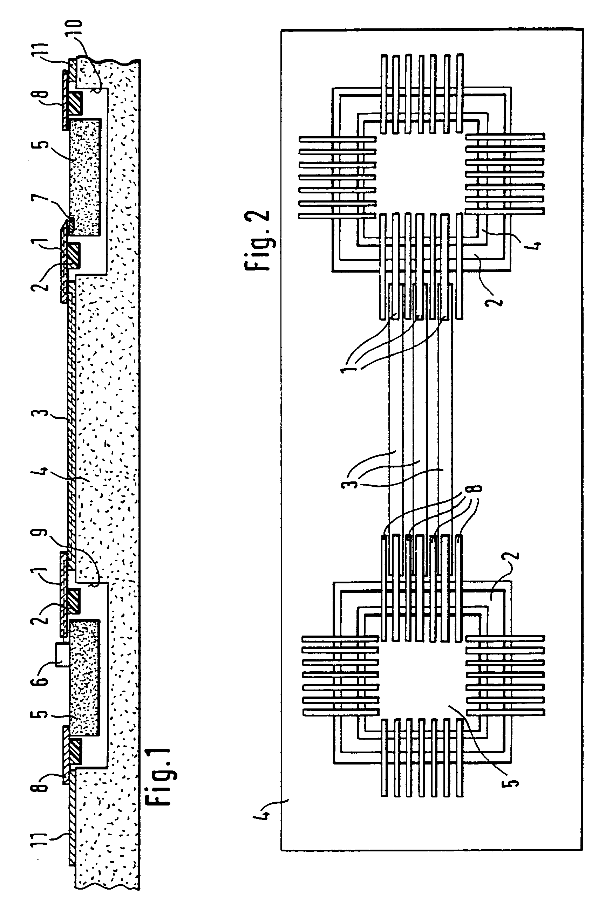

In Fig 1 ist ein Substrat (Leiterplatte) 4 dargestellt, welches Vertiefungen 9, 10 zur Aufnahme von Halbleiterchips 5 aufweist, die integrierte Schaltkreise mit elektrisch und optisch aktiven Bauelementen tragen. Die Halbleiterchips sind nicht starr, sondern durch elektrische Leitungselemente 8 mit dem Substrat 4 verbunden. Sowohl die elektischen Leitungselemente, in der Regel metallische Leiterstreifen, wie auch optische Leitungselemente 1, Glasfasern oder photolithographisch erzeugte optische Wellenleiter, sind auf einem flexiblen Träger 2 aus Polyimid befestigt, der vor der Verbindung mit dem Chip einerseits und dem Substrat andererseits aus einer größeren flexiblen Leiterplatte aus Trägermaterial ausgestanzt wurde. Beim Stanzvorgang wurde jeweils nur das Trägermaterial durchtrennt, so daß sowohl die zuvor auf der Leiterplatte erzeugten elektrischen, wie auch die optischen Leitungselemente unbeschädigt blieben und nach beiden Seiten über das Trägermaterial 2 überstehen.

Wie in Fig 1 zu sehen, sind die elektrischen Leitungselemente 8 mit Leiterbahnen 11 des Substrates 4 verbunden. Die als optische Wellenleiter ausgebildeten optischen Leitungselemente 1 sind mit Lichtquellen 6 oder Empfangsdioden 7 auf den Halbleiterchips und mit auf dem Substrat aufgebrachten optischen Wellenleitern 3 optisch gekoppelt. Eine direkte mechanische Verbindung zwischen optischem Leitungselement einerseits und Halbleiterchip oder Substrat ist in Fig 1 nicht dargestellt. Falls nötig ist sie durch Kleben oder Vergießen, bei thermoplastischem Wellenleitermaterial auch durch Verschweißen, herstellbar. Die optische Kopplung wird durch eine geeignete Endflächenpräparation der optischen Leitungselemente und der Substratwellenleiter erreicht. Je nach Art der Lichtquelle oder Lichtsenke kann eine senkrechte Endfläche (butt coupling) oder eine abgeschrägte und eventuell verspiegelte Endfläche (Fig 1) vorgesehen werden. Auch speziellere Endflächenformen wie Kugellinsen, Zylinderlinsen oder Taper sind möglich.

Fig 2 zeigt in Draufsicht die Anordnung der optischen Leitungselemente 1 zwischen elektrischen Leitungselementen 8. Mit der Befestigung der beiderseits der optischen Leitungselemente 1 befindlichen elektrischen Leitungselemente an Chip 5 und Substrat 4 - dessen Leiterbahnen in Fig 2 nicht dargestellt sind - werden die optischen Leitungselemente in ihrer Lage fixiert und justiert. Der flexible Träger gleicht unterschiedliche Ausdehnungskoeffizienten von Substrat und Halbleiterchip aus, so daß mechanische Spannungen und Temperatureinflüsse keine negativen Auswirkungen auf die Verbindung haben.

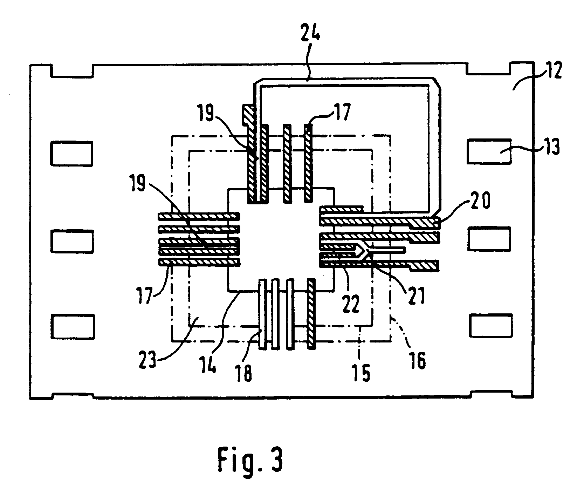

Der flexible Zwischenträger hat eine große Zahl weiterer Vorteile, die anhand von Fig 3 aufgezeigt werden:
In Fig 3 ist eine aus für den flexiblen Zwischenträger geeignetem Material hergestellte flexible Leiterplatte 12 dargestellt, die wie ein Kinofilm mit Transportlöchern 13 versehen ist. Auf der Leiterplatte sind elektrische Leitungselemente 17 und optische Leitungselemente 18, 19 aufgebracht, die über die Schnittkante 14 eines von der Rückseite der Leiterplatte her eingestanzten Ausschnitts, in den später der Halbleiterchip eingehängt wird, hinausragen. Die elektrischen Leitungselemente sind zum Teil mit Anschlußfeldern 20 versehen, an denen sie zu Prüfzwecken mit Testadaptern kontaktiert werden können. Sie reichen weit über eine äußere Stanzlinie 16, entlang derer später der flexible Zwischenträger aus der flexiblen Leiterplatte herausgestanzt wird, hinweg in einen äußeren Bereich der flexiblen Leiterplatte, der nach Herausstanzen des flexiblen Zwischenträgers als Verschnitt übrigbleibt.

In diesem äußeren Bereich der flexiblen Leiterplatte verläuft auch eine optische Testschleife 24, die zwei optische Leitungselemente 19 miteinander verbindet, so lange der Zwischenträger mit dem eingesetzten Halbleiterchip noch nicht von der flexiblen Leiterplatte getrennt ist. Nach dem Ausstanzen oder -ätzen entlang der Stanzlinie 16 werden durch einen weiteren Stanzvorgang, der von der Rückseite her, entlang einer Stanzlinie 15 erfolgt, die zum Substrat hin gerichteten Enden der Leitungselemente soweit freigelegt, daß sie problemlos mit der Leiterstruktur des Substrats verbunden werden können. Als Zwischenträger verbleibt lediglich der zwischen den Stanzlinien 14 und 15 gelegene Bereich 23, in dem die Leitungselemente befestigt sind.

Dieser Bereich kann in seiner Gestalt und Ausdehnung variiert werden und bietet Platz für die Anlage von Verknüpfungen optischer Ein- und Ausgänge wie Verzweigungen oder Laufzeitstrecken, für die dann keine Chipfläche benötigt wird. Eine Auffächerung von chipseitig dicht nebeneinanderliegenden Leitungselementen kann ebenfalls auf dem Zwischenträger erfolgen.

## Patentansprüche

1. Schaltkreisanordnung mit einem erste Bauelemente tragenden Substrat (4) und einem mit diesem über einen flexiblen Zwischenträger (2) auf dem Leitungselemente (1,8) geführt sind, verbundenen, zweite Bauelemente (6,7) enthaltenden integrierten Schaltkreis (5), dadurch gekennzeichnet, daß die ersten und zweiten Bauelemente optische aktive Bauelemente (6, 7) oder optische Wellenleiter (3) umfassen, und daß wenigstens ein Teil der über den flexiblen Zwischenträger (2) geführten Leitungselemente (1,8) optische Wellenleiter (1) sind, die mit optisch aktiven Bauelementen (6,7) oder optischen Wellenleitern (3) auf dem Substrat und in dem integrierten Schaltkreis (5) gekoppelt sind.

2. Schaltkreisanordnung nach Anspruch 1, dadurch gekennzeichnet, daß als Leitungselemente fungierende optische Wellenleiter (1) in Zwischenräumen zwischen elektrischen Leitungselementen (8) auf dem flexiblen Zwischenträger (2) geführt und befestigt sind.

3. Schaltkreisanordnung nach Patentanspruch 1 oder 2, dadurch gekennzeichnet, daß die als Leitungselemente fungierenden optischen Wellenleiter (1) auf den flexiblen Zwischenträger (2) aufgeklebt und/oder in eine optische Vergußmasseschicht eingebettet sind.

4. Schaltkreisanordnung nach Patentanspruch 1 oder 2, dadurch gekennzeichnet, daß die als Leitungselemente fungierenden optischen Wellenleiter (1) als optische Streifenwellenleiter photolithographisch auf dem flexiblen Zwischenträger (2) erzeugt sind.

5. Schaltkreisanordnung nach einem der vorstehenden Ansprüche, dadurch gekennzeichnet, daß auf dem flexiblen Zwischenträger (2) optische Funktionselemente wie Verzweigungen (21), Richtkoppler, Wellenleiter-Endstücke angeordnet sind.

6. Verfahren zur Herstellung einer Schaltkreisordnung nach einem der Ansprüche 1 bis 5, dadurch gekennzeichnet, daß auf dem flexiblen Zwischenträger (2) vorgesehene optische und elektrische Leitungselemente (1,8) sowie zusätzlich Prüfadapteranschlüsse (20) und optische Testschleifen (24) auf eine flexible Leiterplatte aus Zwischenträgermaterial aufgebracht werden, daß danach eine zur Aufnahme des integrierten Schaltkreis geeignete Ausnehmung so aus der Leiterplatte herausgestanzt oder herausgeätzt wird, daß für die Verbindung zum integrierten Schaltkreis benötigte Leitungselemente in die Ausnehmung hinein überstehen, daß der integrierte Schaltkreis in diese Ausnehmung eingesetzt und mit den überstehenden Leitungselementen verbunden wird und daß nach einer Funktionsprüfung, die unter Verwendung der auf der flexiblen Leiterplatte geschaffenen Prüfadapteranschlüsse und optischen Testschleifen erfolgt, in einem weiteren, gleichartigen Stanz- oder Ätzvorgang der Zwischenträger (2) mit dem integrierten Schaltkreis (5) aus der flexiblen Leiterplatte herausgetrennt, in eine im Subtrat vorbereitete Vertiefung (9, 10) eingesetzt und mit seinen über seine äußere Begrenzung überstehenden optischen und elektrischen Leitungselementen (1, 8) mit dem Subtrat verbunden wird.

## Claims

1. Circuit arrangement comprising a substrate (4) supporting first components and an integrated circuit (5) connected to said substrate (4) via a flexible intermediate carrier (2) on which line elements (1, 8) are routed, said integrated circuit (5) containing second components (6, 7), characterized in that the first and second components comprise optical active components (6, 7) or optical waveguides (3), and in that at least some of the line elements (1, 8) routed over the flexible intermediate carrier (2) are optical waveguides (1) which are coupled to optically active components (6, 7) or optical waveguides (3) on the substrate and in the integrated circuit (5).

2. Circuit arrangement according to Claim 1, characterized in that optical waveguides (1) functioning as line elements are routed and fixed in gaps between electrical line elements (8) on the flexible intermediate carrier (2).

3. Circuit arrangement according to Patent Claim 1 or 2, characterized in that the optical waveguides (1) functioning as line elements are glued onto the flexible intermediate carrier (2) and/or are embedded in an optical encapsulation-material layer.

4. Circuit arrangement according to Patent Claim 1 or 2, characterized in that the optical waveguides (1) functioning as line elements are produced photolithographically on the flexible intermediate carrier (2) as optical strip waveguides.

5. Circuit arrangement according to one of the preceding claims, characterized in that optical functional elements such as branches (21) directional couplers or waveguide end pieces are arranged on the flexible intermediate carrier (2).

6. Method of producing a circuit arrangement according to one of Claims 1 to 5, characterized in that optical and electrical line elements (1, 8) provided on the flexible intermediate carrier (2) and, in addition, test-adapter terminals (20) and optical test loops (24) are deposited on a flexible printed circuit board made of intermediate-carrier material, in that a cutout suitable for receiving the integrated circuit is then punched or etched out of the printed circuit board, in that line elements needed for the connection to the integrated circuit project into the cutout, in that the integrated circuit is inserted into said cutout and is connected to the projecting line elements, and in that, after a functional test carried out using the test-adapter terminals and optical test loops provided on the flexible printed circuit board, the intermediate carrier (2), together with the integrated circuit (5) is cut out of the flexible printed circuit board in a further, similar punching or etching operation, inserted in a recess (9, 10) provided in the substrate and connected to the substrate by means of its optical and electrical line elements (1, 8) which project beyond its outer boundary.

## Revendications

1. Dispositif de circuit comportant un substrat (4) qui porte des premiers composants et un circuit intégré (5) qui est relié à ce substrat au moyen d'un support intermédiaire flexible (2) sur lequel sont guidés des éléments de conduction (1,8) et qui contient des seconds composants (6,7), dispositif caractérisé par le fait que les premiers et les seconds composants contiennent des composants optiques actifs (6,7) ou des guides d'ondes optiques (3) et par le fait qu'au moins une partie des éléments de conduction (1,8) guidés au moyen du support intermédiaire flexible (2) sont des guides d'ondes optiques (1) qui sont couplés avec les composants optiquements actifs (6,7) ou avec les guides d'ondes optiques (3) qui sont sur le substrat et dans le circuit intégré (5).

2. Dispositif de circuit selon la revendication 1, caractérisé par le fait que des guides d'ondes optiques (1), faisant fonction d'éléments de conduction, sont guidés et fixés dans les espaces intermédiaires existant entre les éléments de conduction électrique (8) sur le support intermédiaire flexible (2).

3. Dispositif de circuit selon la revendication 1 ou 2, caractérisé par le fait que les guides d'ondes optiques (1) faisant fonction d'éléments de conduction sont collés sur le support intermédiaire flexible (2) et/ou sont enrobés dans une couche de masse optique fondue.

4. Dispositif de circuit selon la revendication 1 ou 2, caractérisé par le fait que les guides d'ondes optiques (1) faisant fonction d'éléments de conduction sont produits sur le support intermédiaire flexible (2) sous forme de guides d'ondes optiques à rubans par voie photolithographique.

5. Dispositif de circuit selon l'une des revendications précédentes, caractérisé par le fait que sur le support intermédiaire flexible (2) sont disposés des éléments fonctionnels optiques comme des branchements (21), des coupleurs directifs, des embouts de guides d'ondes.

6. Procédé de fabrication d'un dispositif de circuit conforme à l'une des revendications 1 à 5, caractérisé par le fait que l'on rapporte sur le support intermédiaire flexible (2) des éléments de conduction optique et électrique (1,8) prévus, ainsi qu'en outre des raccords adaptateurs pour test (20) et des boucles de test optique (24) sur une carte de circuit imprimé flexible constituée du matériau du support intermédiaire, par le fait qu'ensuite on réalise, par estampage ou par attaque chimique, dans la carte du circuit imprimé, un évidement approprié pour recevoir le circuit intégré de façon telle que les éléments de conduction nécessaires pour la liaison avec le circuit intégré dépassent au-delà de l'évidement, par le fait que l'on insère le circuit intégré dans cet évidement et qu'on le relie avec les éléments de conduction qui dépassent et par le fait qu'après une épreuve de fonctionnement, qui se fait en employant les raccords adaptateurs de test et les bouches de test optiques créés sur la carte de circuit imprimé flexible, au cours d'un autre processus, identique, d' estampage ou d'attaque chimique, on sépare le support intermédiaire (2), avec le circuit intégré (5), d'avec la carte de circuit imprimé flexible, on l'insère dans un évidement (9,10) préparé dans le substrat et on le relie au substrat par ses éléments de conduction optique et électrique (1,8) qui dépassent au-delà de sa limite extérieure.
